# EUROPEAN PATENT APPLICATION

(11) **EP 0 867 728 A2**
(43) Date of publication of application: **30.09.1998**
(21) Application number: 98105382.0
(22) Date of filing: 25.03.1998
(51) Int. Cl.: G01R 33/09

(54) **Magnetoresistive effect sensor and method for producing the same**

(30) Priority: 26.03.1997 JP 73210/97; 19.03.1998 JP 70235/98
(71) Applicant: Delta Tooling Co., Ltd., Hiroshima 736 (JP)
(72) Inventor: Honda, Shigeo, Hiroshima-shi, Hiroshima (JP); Yamane, Hideyuki, Aki-ku, Hiroshima-shi, Hiroshima (JP)
(74) Representative: Eisenführ, Speiser & Partner

(57) **Abstract**

The present invention relates to magnetoresistive effect sensors, particularly using giant magnetoresistive effect, and to method for producing the sensors. The magnetoresistive effect sensor of the invention has a multilayer structure (1) formed by alternatively depositing ferromagnetic layers (3) of Co and nonmagnetic layers (4) of Au or Ag, wherein the nonmagnetic layers (4) contain Co particles (5) dispersed non-uniformly therein so as to have magnetoresistive effect in a range of 1 - 2 Koe. particularly the nonmagnetic layers (4) are deposited with Ag and have the thickness in a range of 5 - 9 Å of each layer (4). The method of producing a magnetoresistive effect sensor (1) comprises steps of depositing alternatively Co to form layers to form the ferromagnetic layers (3) and Ag or Au to form the nonmagnetic layers (4) on a substrate, and annealing the multilayer (1) to cause Co from the ferromagnetic layers (3) to disperse as Co particles (5) non-uniformly in the nonmagnetic layers (4).

## Description

### FIELD OF THE INVENTION

The present invention relates to magnetoresistive effect sensors, particularly using granular giant magnetoresistive effect, and to method for producing the sensors.

### BACKGROUND OF THE INVENTION

Magnetoresistive effect sensors are used as sensors sensible to magnetic field, especially used for the magnetic memory devices to read data recorded on the magnetic memory media. For the application, the magnetic sensors are needed to have highly sensibility to the magnetic field change. Ability of the magnetoresistive effect sensors is estimated by a magnetoresistive ratio (MR ratio), which is kept in layers composing the sensor which is provided with magnetoresistive effect.

MR ratio is defined as a ratio of difference between a resistance ρₓ of a sensor under a magnetic field Hx and the saturated resistance ρₛ under the saturated magnetization due to a magnetic field H=15kOe divided by the saturated resistance ρₛ. Maximum MR ratio means the MR ratio under Hx = 0 Oe.

Regarding to the prior art, Fe-Ni alloy layers were used as the magnetoresistive effect layers, and in this example, the MR ratio of the alloy is only several percents. The value was so low for the magnetic sensors that magnetoresistive effect layers having higher Mr ratio have been required.

There are reported synthetic lattice layers which are laminated by alternative depositing ferromagnetic layers of Fe and non-magnetic layers of Cr with each layer having several-atom depth, which exhibit a MR ratio of about 16% in use at room temperature as the magnetoresistive effect layers.

Phenomena to be seen in a multilayer combining ferromagnetic layers with non-magnetic conductive layers are referred to as giant magnetoresistive (GMR) effect. The phenomena have been considered to result from electron spins of Fe in adjacent ferromagnetic layers through a nonmagnetic layer being oriented parallel to each other in the same direction under magnetic fields to reduce electric resistance through the conductive layers, whereas the spins are antiparallel in the adjacent layers under no magnetic field. This type of magnetoresistive sensor uses the anti-ferromagnetism existing in the ferromagnetic layers divided by conductive layers in the multilayer.

Regarding to the magnetic sensor using the GMR effect, Japanese patent Publication 6-326377 A discloses magnetoresistive effect layers comprising the magnetic layers of Fe, Ni or Co and the nonmagnetic layers of Cu, Ag or Au.

The magnetoresistive effect layers using a multilayer of anti-ferromagnetic bonding type provides high MR ratio, but have disadvantages for the magnetic sensors, forming a large hysteresis loop in the magnetization curve.

For avoiding such a magnetoresistive hysteresis phenomena, a number of proposals have been put forward for using granular layers as the nonmagnetic layers, for example, Co-Ag granular layers comprising Ag layers and Co particles to be contained therein uniformly. The magnetoresistive sensor of Co-Ag granular layers dose not almost show a hysteresis loop in the magnetoresistive curve, and is isotropic to magnetic resistance with higher MR ratio under low level of magnetic fields of hundreds Oe. However, the layers have low MR ratio of 1 to 2% and low magnetic sensitivity in higher magnetic field intensity of 1 to 2 kOe. This property of the layers is not suitable for magnetoresistive effect sensors to be used to detect high magnetic field of 1 to 2 kOe.

### SUMMARY OF THE INVENTION

An object of the present invention is to provide magnetoresistive effect sensor using GMR effect having a high MR ratio, no hysteresis and high sensitivity in high magnetic field such as 1 to 2 kOe.

Another object of the present invention is to provide a method of producing a magnetoresistive effect sensor using GMR effect having a high MR ratio, no hysteresis and high field sensitivity in high magnetic field such as 1 to 2 kOe.

To attain the object, the present invention provides a magnetoresistive effect sensor having a multilayer formed by alternatively depositing ferromagnetic layers of Co and non-magnetic layers of Ag or Au. The nonmagnetic layers contain particles of Co dispersed non-uniformly by annealing the multilayer, annealing growing the Co particles in the nonmagnetic layers. The heat treatment causes the non-magnetic layers within the multilayer to exhibit the giant magnetoresistive effect. Thus, the sensor shows a great change in magnetoresistance which is due to a change in outer magnetic field in a range of 1 - 2kOe.

The invention provides a magnetoresistive effect sensor having a multilayer formed by alternatively laminating soft magnetic layers as the ferromagnetic layers and granular layers as the nonmagnetic layers to obtain the high maximum MR ratio and high magnetic sensitivity in a range of 1 - 2 kOe of the magnetic field.

Particularly, layers of an alloy of two or more iron-group metals Fe, Ni and Co are used as the soft magnetic layers, and layers of Co-Ag are used as nonmagnetic conductive layers. The nonmagnetic layers contain particles of Co or other iron-group metal dispersed non-uniformly, which are diffused from the soft magnetic layers during heat-treating the multilayer. The heat treating causes the nonmagnetic layers within the multilayer to exhibit the granular giant magnetoresistive effect. Thus, the sensor shows high sensitivity of magnetoresistance by a change in outer magnetic field of a range of 1 - 2 kOe.

Further, the invention includes the sensor comprising a multilayer laminated alternatively with soft magnetic layers of Fe-Co alloy and granular layers of silica (SiO₂) with Fe particles dispersed therein.

Furthermore, the invention includes the sensor comprising a multilayer deposited alternatively with soft magnetic layers of Fe with silica (SiO₂) dispersed therein and granular layers of Ag with Co particles contained. This multilayer exhibits granular giant magnetic effect in a range of 1 - 2 kOe of the magnetic field.

The method of producing the magnetoresistive effect sensors comprises steps of depositing alternatively ferromagnetic layers of Co and non-magnetic layers of any one of metals Cu, Ag and Au to form a multilayer on a substrate; and annealing the multilayer to disperse Co particles non-uniformly in the non-magnetic layers. By annealing, Co in each magnetic layers diffuse into the adjacent non-magnetic layer and to disperse as fine particles in said layer to form granular giant magnetoresistive effect. Thus, the sensor produced by this method shows high sensitivity of magnetoresistance in a range of 1 - 2 kOe of magnetic field .

Particularly, in the depositing step of the method, the ferromagnetic layers can comprises any alloy of iron group metals in place of Co element, and in the annealing step, in the same manner, the particles of at least one element of the iron-group dispersed non-uniformly in the non-magnetic layers.

In another aspect of the invention, a method of producing a magnetoresistive effect sensor comprises a step of alternatively depositing soft ferromagnetic layers of FeCo alloy and granular layers of silica (SiO₂) with iron particles dispersed therein.

In another aspect of the invention, a method of producing a magnetoresistive effect sensor comprises a step of alternatively depositing soft magnetic layers of Fe with silica (SiO₂) dispersed therein and granular layers of Ag with Co particles contained. This multilayer exhibits granular giant magnetic effect in a range of 1 - 2 kOe of the magnetic field.

### BRIEF DESCRIPTION OF DRAWINGS

The present invention is described in details, below, in reference to the drawings, in which;
Figure 1A shows a schematic sectional view of a multilayer structure comprising ferromagnetic layers and nonmagnetic layers according to the present invention.
Figure 1B shows a schematic sectional view of a multilayer structure partially enlarged comprising ferromagnetic layers and nonmagnetic layers according to the present invention.
Figure 2A is a graph showing a relation between maximum MR ratio and thickness regarding to a multilayer [Co(3Å)/Ag(tÅ)]40 according to the invention.
Figure 2B is a graph similar to Figure 2A regarding a multilayer [Co(2Å)/Au(tÅ)]50.
Figures 3A, 3B and 3C are graphs showing MR ratio curves of a multilayer [Co(3Å)/Ag(7Å)]40 before annealing, after annealed at 350°C and after annealed at 400°C respectively.
Figures 3D, 3E and 3F show graphs of MR ratio curves of a multilayer [Co(2Å)/Au(6Å)]50 before annealing, after annealed at 300°C and after annealed at 350°C respectively.
Figure 4A is a graph showing a relation between maximum MR ratio and annealing temperature regarding a multilayer [Co(3Å)/Ag(tÅ)]40, thicknesses t being 7 and 10Å.
Figure 4B is a graph showing a relation between sensitivity (represented by maximum MR ratio/FWHM) and annealing temperature regarding the same multilayer as Figure 4A.
Figures 5A and 5B show graphs similar to Figures 4A and 4B respectively regarding a multilayer [Co(2Å)/Au(6Å)]50.
Figure 6 shows a graph of a relation between maximum MR ratio and thickness t of a multilayer [FeCo(3Å)/Co-Ag(tÅ)]10, showing the maximum Mr ratios to magnetic fields applied longitudinally in, transversely in, and perpendicularly to a main plane of the multilayer.
Figures 7A and 7B show graphs of magnetization of a multilayer [FeCo(3Å)/Co-Ag(80Å)]10 before annealing and after annealed at 350°C respectively.
Figures 8A, 8B and 8C show MR ratio curves of a multilayer [FeCo(3Å)/Co-Ag(80Å)]10 before annealing, after annealed at 350°C, and after annealed at 400°C respectively. to magnetic field.
Figure 9A and 9B show similar graphs to Figure 7A and 7B respectively regarding a multilayer [FeCo(3Å)/Co-Ag(200Å)]10.
Figures 10A,10B and 10C show MR ratio curves of a multilayer [FeCo(3Å)/Co-Ag(200Å)]10 similar to Figures 8A, 8B and 8C.
Figure 11A is a graphs showing a relation between maximum MR ratio of a multilayer [FeCo(3Å)/Co-Ag(80,200Å)]10 and annealing temperature (AT), and Figure 11B is a graph showing a relation between magnetic sensitivity of the same multilayer as Figure 11A and annealing temperature.
Figure 12A is a graph showing a relation between saturation resistance under 15kOe of magnetic field and thickness t of a multilayer [FeCo(3Å)/Fe-SiO2(tÅ)]10, and Figure 12B is a graph showing a relation between deference between resistances under the 15kOe- and zero- magnetic fields and thickness t of the same multilayer as Figure 12A.
Figure 13A shows a graph of a relation between maximum MR ratio and thickness of a multilayer [FeCo(3Å)/Fe-SiO2(tÅ)]10 and Figure 13B shows a graph of sensitivity (maximum MR ratio / FWHM) of the same multilayer as Figures 13A and thickness.
Figure 14 shows MR ratio curve and resistance change due to a change in magnetic field.
Figures 15A and 15B are graphs showing the relations similar to figures 13A and 13B respectively, regarding [Fe-SiO2(tÅ)/Co-Ag(tÅ)]10.
Figures 16A and 16B are graphs showing the same relations as Figures 12A and 12B respectively, regarding [Fe-SiO2(tÅ)/Co-Ag(tÅ)]10.
Figure 17 shows a graph of MR ratio curve of a multilayer [Fe-SiO2(tÅ)/Co-Ag(tÅ)]10.

### EMBODIMENT OF THE INVENTION

In the first embodiment of magnetoresistive effect sensor of the present invention, a multilayer is formed by alternatively laminating ferromagnetic material layers and non-magnetic material layers which are superposed each other. The ferromagnetic material layers are formed of Co. The non-magnetic material layers are formed of the noble metals Ag or Au which has electric conductivity.

The two kind of layers are formed by depositing from gas phase of the metals onto the surface of the layers in turns.

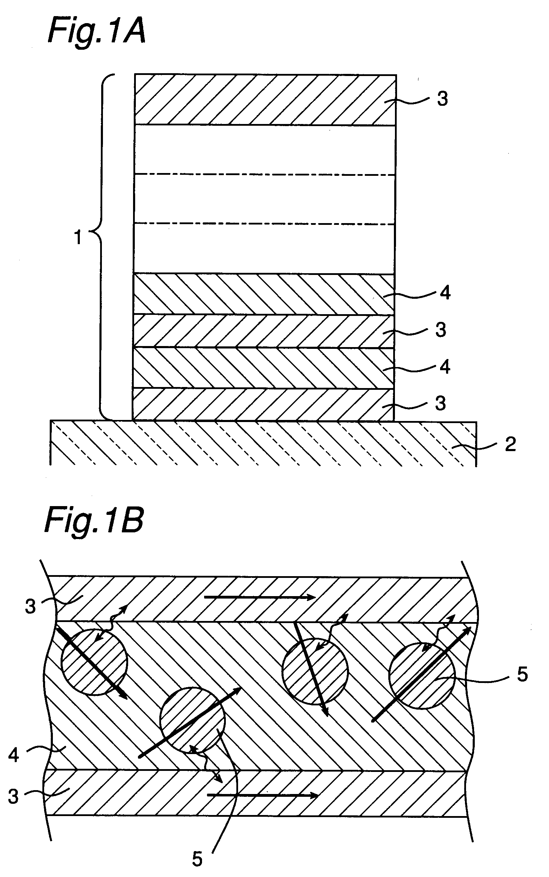

For a process of forming the multilayer, vapor deposition or spattering technique can be adopted. The two kind of layers, magnetic layers 3 and nonmagnetic conductive layers 4, as shown in Figure 1A are controlled to be deposited as each thin film having desired thickness to obtaine the desired number of the layers to form a multilayer 1 on a substrate 2.

In the multilayer Co/Ag or Co/Au, Co particles is inserted into a nonmagnetic conductive layers close to the interface between Co layers and Ag (or Au) layers. As shown Figure 1B, interaction between the supermagnetic Co particles 5 and ferromagnetic Co layers 3 causes high magnetic sensitivity to occur in a range of 1 - 2kOe of high magnetic field.

The nonmagnetic layers preferably may is deposited with Ag and have thickness in a range of 5 - 9 Å a layer.

The multilayer formed is annealed at a high temperature to disperse as Co particles 5 non-uniformly in the nonmagnetic layers 2 and to increase maximum MR ratio and magnetic sensitivity.

In the method of using Au deposited for the nonmagnetic layers and the annealing temperature is adopted to be in a range of 200 - 350 °C to improve maximum MR ratio of the sensor. In the case of Ag deposited for the nonmagnetic layers, the annealing temperature preferably may be in a range of 200 - 400 °C to improve further magnetic sensitivity .

The annealing of the multilayer causes crystal growth of Co particles in the nonmagnetic layers and facilitates magnetization of the super-paramagnetic Co particles to increase MR ratio and further sensitivity.

In a second embodiment of the invention, a multilayer comprises layers containing two or more iron-group metals Fe, Ni and Co used as the soft magnetic layers and layers of Ag used as nonmagnetic conductive layers. The multilayer is formed by alternatively depositing soft magnetic layers of the alloy and granular layers as the nonmagnetic layers of Co-Ag.

The material of soft magnetic layers may be selected from FeCo, FeNi and FeNiCo alloys. the soft magnetic layers may be deposited by spattering the alloy or two metals containing Fe,Ni and Co using magnetron spatter technique, and also nonmagnetic layers may be deposited by spattering Co metal attached on the Ag target to form Co-Ag films.

The nonmagnetic layers contain particles of Co dispersed non-uniformly, and interaction between the supermagnetic Co particles in the granular layers and the soft magnetic layers of FeCo or the like, increases maximum MR ratio and magnetic sensitivity in a range of ±3kOe.

the multilayer is preferably annealed at a appropriate temperature to improve the MR properties. Annealing causes Co particles dispersed in the granular layers to grow slightly and facilitates magnetization of the multilayer so that the multilayer further increases in MR ratio. Thus the sensor shows granular giant magnetoresistive effect and high sensitivity of magnetoresistance by a change in outer magnetic field in a range of 1 - 2 kOe.

It is desirable that the soft magnetic layers comprises any one of FeCo, FeNi and FeNiCo alloys. Particularly, FeCo alloy may be selected for the layers, and in this case, the non-magnetic layers formed of Co-Ag may is prepared with thickness in the range of 80 - 200Å a layer.

In the combination of FeCo based soft magnetic layer and Co-Ag based non-magnetic layer, the non-magnetic layers may be formed to be granular layers of Ag which contains magnetic Co particles. the multilayer preferably may be annealed at a temperature in the range of 200 - 400°C. The annealing allows the magnetic particulate crystals of Co to grow in the layers in order to improve MR ratio needed as a magnetoresistive effect sensor.

In another embodiment of the present invention, in a multilayer of the magnetoresistive sensor, the ferromagnetic material layers 2 are formed of FeCo and the nonmagnetic isolating material layers 4 of silica (SiO₂) with Fe particles contained non-uniformly in each layer, while the SiO₂-Fe layers act as granular layers. The sensor using the multilayer has average high electric resistance because of the nonmagnetic isolating layers 4 of silica (SiO₂) and shows granular giant magnetoresistive effect in the range of 1 - 2 kOe of the magnetic field.

The multilayer is formed by alternatively depositing the ferromagnetic material layers 3 of FeCo and the nonmagnetlc layers 4 of SiO₂ -Fe . The ferromagnetic material spattered may be deposited by spattering Fe-Co alloy and the nonmagnetic layers by spattering Fe on the SiO₂ target, in desired thickness a layer.

In another embodiment, in a multilayer of the magnetoresistive effect sensor, soft magnetic layers are formed of silica SiO₂ with Fe particles contained, and non-magnetic material layers are formed of Ag with Co particles dispersed non-uniformly in the layers. In the multilayer, interaction between the supermagnetic particles of Co in the granular layers and soft magnetic layers causes the super-paramagnetic Co particles to be magnetized easily so that the multilayer increases in maximum MR ratio and magnetic sensitivity in a range of ±3kOe.

The multilayer is formed by alternatively depositing the ferromagnetic material layers 3 of SiO₂-Fe and the nonmagnetic layers 4 of Ag-Co. In the process, the ferromagnetic material may be deposited by spattering SiO₂ on Fe target and the nonmagnetic layers may be deposited by spattering Co chips on a Ag target desires thickness using high frequency spattering technique.

### (EXAMPLE 1)

Magnetoresistive effect multilayers were formed on glass substrates by alternative depositing Co and Ag to form several ten layers of Co and as many layers of Ag superposed each other by using vapor deposition technique. Each Ag layer is controlled to have different thicknesses of 5 to 16Å, while thickness of the Co layer is 3Å constant. The multilayers formed was annealed at various temperatures of 200 - 400°C for several minutes. In the same manner, multilayers of Co/Au layers were also formed.

The multilayers were provided for measurement of the magnetic properties. The measurement was conducted under maximum applied magnetic field of 15kOe using Vibrating Sample Magnetometer at room temperature. Magnetoresistance was determined by using direct current four-terminal resistance technique as the magnetic field applied was varied in a range of magnetic field of ±15 kOe.

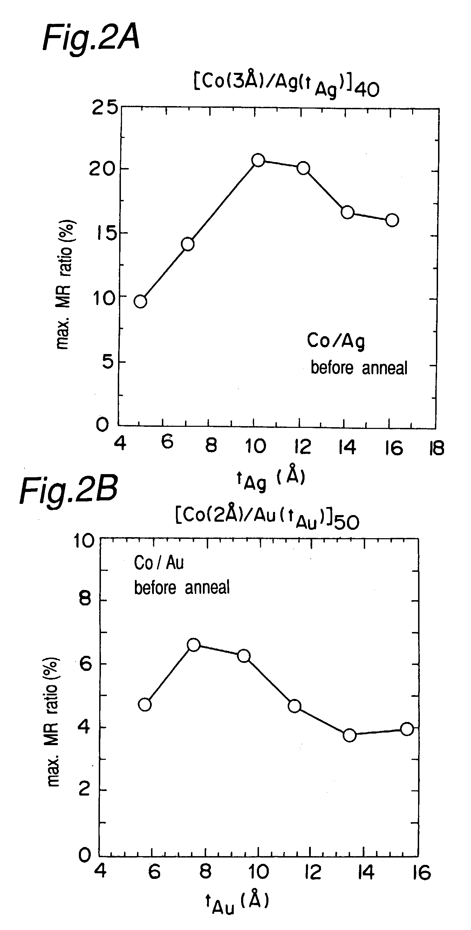

Figures 2A show the experimental results of the magnetoresistive effect multilayer which is laminated with 50 layers of Co in thickness of 3Å a layer and 50 layers of Ag in tÅ a layer (hereinafter indicated in a forme of [Co(3Å)/Ag(tÅ)]40 or the like). For multilayer [Co(3Å)/Ag(tÅ)]50, As shown in Figure 2A, the Ag-layer thickness of 10Å exhibits the peak of the maximum MR ratio 20.7% and the thickness may be controlled in a range of 7 - 16Å to obtain maximum Mr ratio more than 15%.

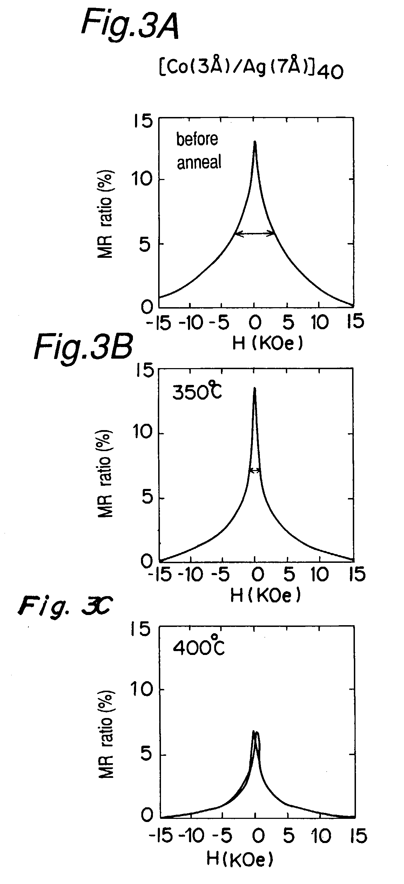

The MR ratio curves of [Co(3Å)/Ag(7Å)]40 to magnetic field are shown in Figure 3A and 3B, by annealing the multilayer at 350°C, the curve is sharpened to lower the full width at half maximum MR ratio as indicated by the arrow in the figures, but the maximum MR ratio dose not change. Further higher-temperature annealing at 400°C decrease the maximum MR ratio and creates hysteresis loop of the MR ratio curve as shown Figure 3C. Annealing the [Co(3Å)/Ag(7Å)]40 at 350°C increases the number of Co particles in Ag layers and grow the Co crystals to facilitate the magnetization of the particles so that maximum MR ratio can increases. Annealing at a higher temperature promotes the crystal growth to ferromagnetize the Co particles, resulting in generating hysteresis and reduction of maximum MR ratio.

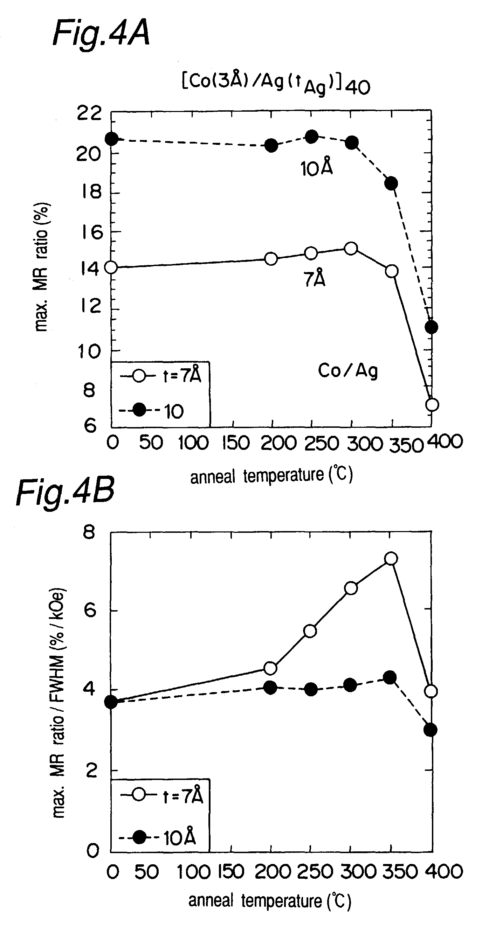

Figures 4A and 4B show effect of annealing temperature on the maximum MR ratio and magnetic sensitivity which is defined as maximum MR ratio divided by full width of half maximum (FWHM) of MR ratio) for Co/Ag multilayer [Co(3Å)/Ag(tÅ)]40 with thickness t of nonmagnetic layers varied in 7Å and 10Å. The maximum MR ratio dos not vary at a annealing temperature up to 300°C and as the temperature is higher than 350°C, the maximum MR ratio is decreased. On the other hand, The multilayer with the thickness of 7Å increases in magnetic sensitivity as the annealing temperature is increased up to 350°C, since the full width at half maximum MR ratio is decreased. However, the multilayer with the thickness of 10Å dose not change in magnetic sensitivity in the temperature range of 200 to 350°C. In the both multilayers, the temperature higher than 400°C decreases the sensitivity.

### (EXAMPLE 2)

Multilayers Co/Au were formed and tested similarly to the Example 1.

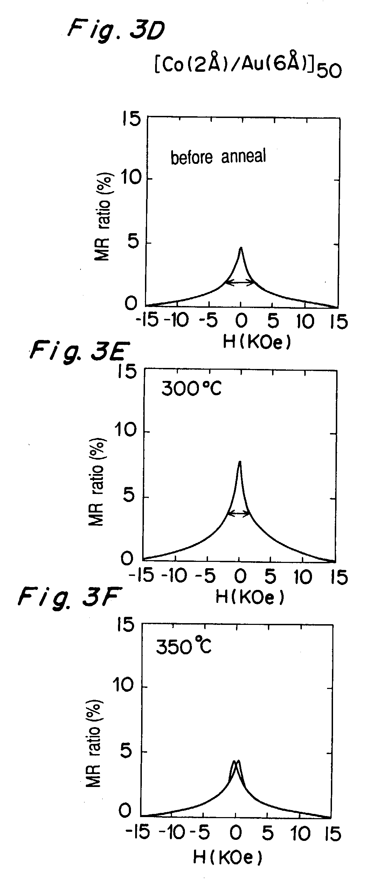

In Figure 2B multilayers [Co(2Å)/Au(tÅ)]50 are higher in maximum MR ratio slightly in the range of thickness of 8 - 10Å the other thickness. In Figures 3D and 3E annealing at 300°C improve the maximum MR ratio and sharpness of the MR curve compared with as-deposited multilayer [Co(2Å)/Au(6Å)]50. The maximum of the peak MR ratio is achieved to be 8% at 300 °C, but, at 350°C of annealing temperature, as shown in Figure 3A the MR ratio is decreased and the hysteresis is created, similarly to the Co/Ag multilayer annealed at 400°C.

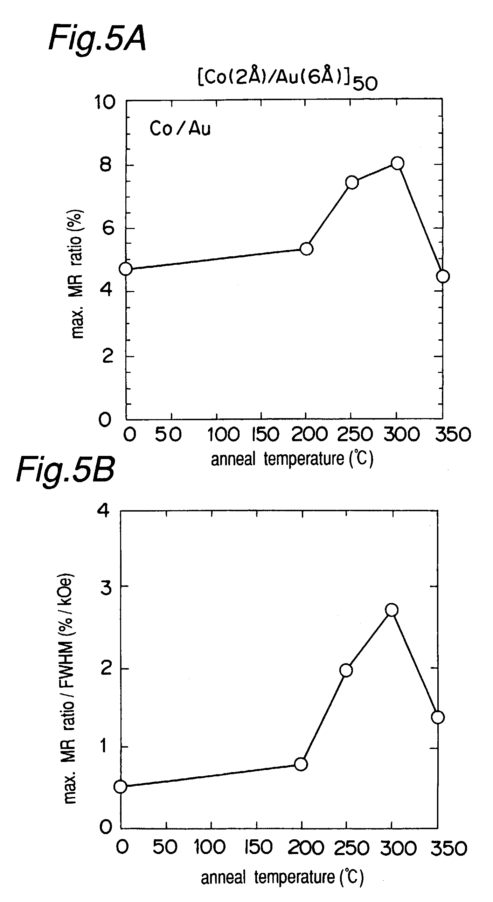

For effect of annealing temperature on the multilayer [Co(2Å)/Au(6Å)]50, as shown in Figure 5A and 5B, the maximum MR ratio of [Co(3Å)/Au(6Å)]50 is increased as the annealing temperature increases in a range of 200 - 300°C and the maximum MR ratio is decreased at the temperature over 300°C. Figure 5B shows that the magnetic sensitivity of [Co(3Å)/Au(6Å)]50 behaves in the same manner as the maximum MR ratio relative to the annealing temperature, the maximum of the magnetic sensitivity being obtained at the same temperature of 300 °C.

### (EXAMPLE 3)

Multilayers were formed of ferromagnetic layers of FeCo alloy and nonmagnetic layers of Co-Ag deposited alternatively on a glass substrate by using high frequency magnetron spattering technique. The multilayers were annealed a various temperatures to disperse Co particles in the nonmagnetic layers which are made to granular layers.

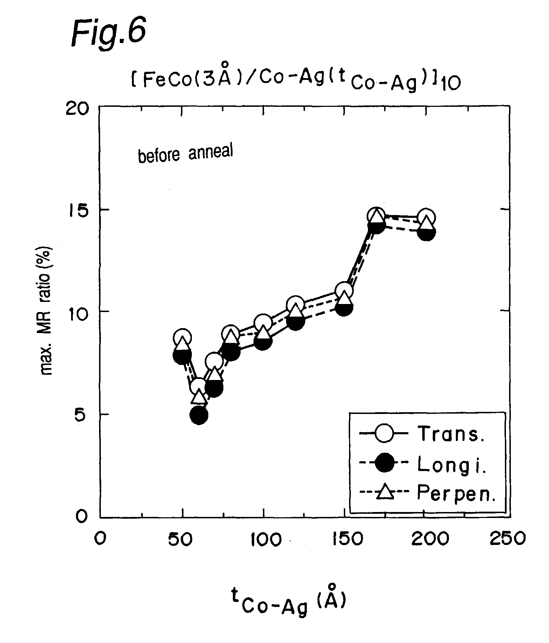

MR ratios were determined for the multilayers [FeCo(3Å)/Co-Ag(tÅ)]10 varying in thickness t a nonmagnetic layer. As the result is shown in Figures 6, higher maximum MR ratio than 10 % can be obtain by increasing the thickness in the range of 80 - 200 Å, particularly in a thickness range of 170 - 200 Å. This Figure 6 shows that the multilayer FeCo/Co-Ag dose not depend on the directions of magnetic field applied to main plane of the multilayer.

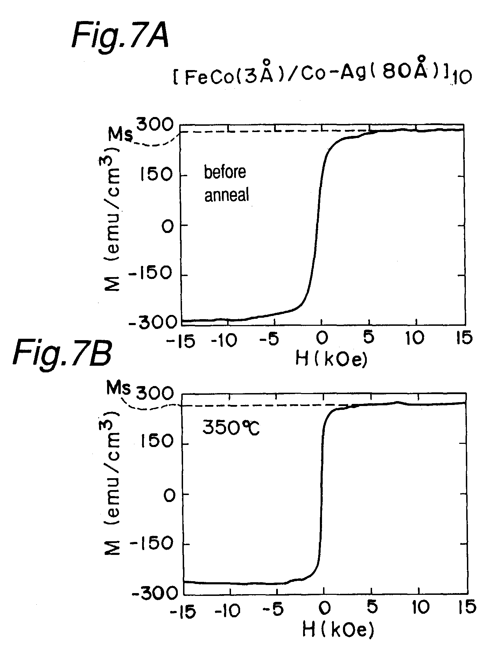

For the multilayers [FeCo(3Å)/Co-Ag(tÅ)]10, the thickness was selected to be 80 and 200 Å, and the annealing temperature was to be 350 and 400°C. Magnetization curves and MR ratios were determined. The multilayer with 80Å after annealing, as shown in Figure 7B, is achieved to the saturation magnetization by lower level magnetic field compared with one before annealing in Figure 7A. The annealing can facilitate magnetization of the multilayers [FeCo/Co-Ag]10.

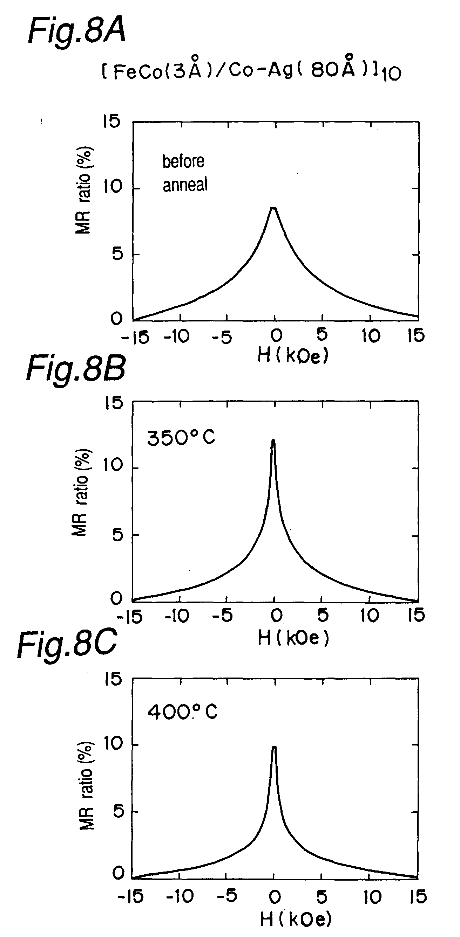

For [FeCo(3Å)/Co-Ag(80Å)]10, in figure 8A, the maximum MR ratio is increased from maximum 8% before annealing to maximum 12% after annealing at 350°C and lowered to 10% at 400°C. Also, annealing lowers the full width at half maximum (FWHM) MR ratio from 5.6kOe before annealing to 1.6kOe after annealing at 350°C and 400°C. the annealing have effect of increasing the gradient of MR ratio curve at magnetic fields of ±3 kOe. Thus, it may be seen that annealing at appropriate temperature improves magnetic sensitivity of the multilayer [FeCo(3Å)/Co-Ag(tÅ)]10.

Annealing [FeCo(3Å)/Co-Ag(80Å)]40 at 350°C increases the number of Co particles in Ag layers and grow the Co crystals to facilitate the magnetization of the particles so that maximum MR ratio can increases. Annealing at further higher temperature close to 400°C promotes the crystal growth to ferromagnetize the Co particles, resulting in generating hysteresis and reduction of maximum MR ratio.

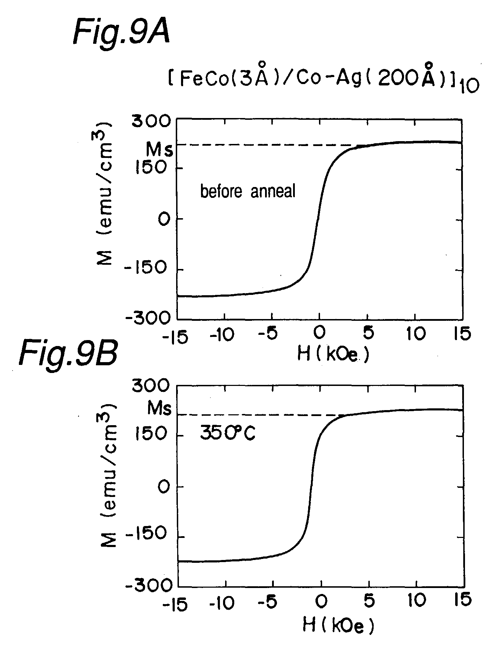

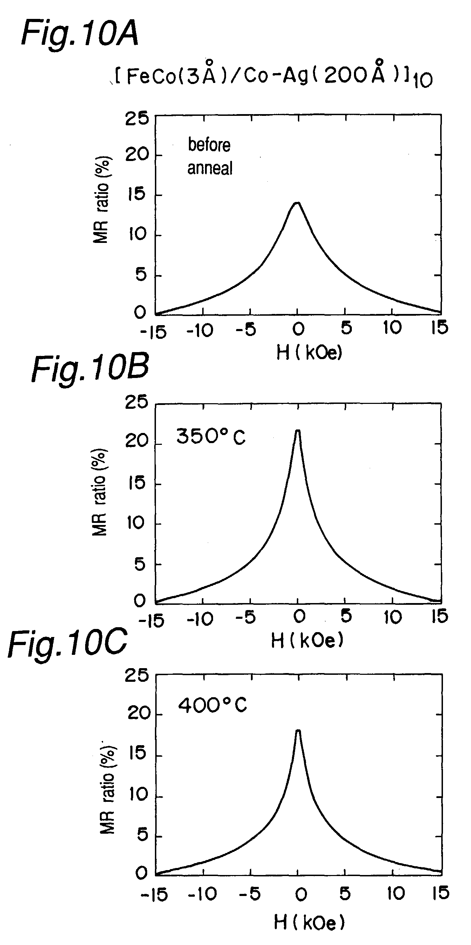

For multilayer [FeCo(3Å)/Co-Ag(200Å)]10, which have thicker layers of Co-Ag, the magnetization curves are shown in Figures 9A and 9B and MR curves are in Figures 10A to 10C. The multilayer shows high maximum MR ratio of 14.5% before annealing and 22.5% after annealing at 350°C, and low FWHM of MR ratio after annealing. The behavior of magnetization and MR ratio of [FeCo(3Å)/Co-Ag(200Å)]10 are similar to those of above-mentioned [FeCo(3Å)/Co-Ag(80Å)]10 with thinner layers of Co-Ag.

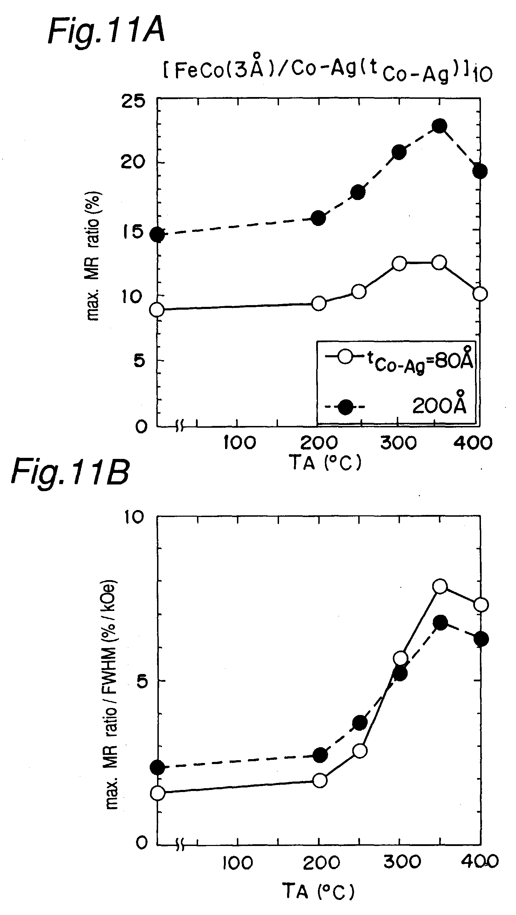

For multilayers FeCo/Co-Ag with 80 and 200Å, Figures 11A and 11B show relations of the maximum MR ratio and magnetic sensitivity (defined as maximum MR ratio / FWHM) respectively with annealing temperature. The two kind of multilayers increase in the maximum MR ratio and magnetic sensitivity as the annealing temperature increases up to 350°C, the annealing at 350°C providing peak values thereof.

### (EXAMPLE 4)

Multilayers FeCo/Fe-SiO2 were formed of ferromagnetic layers of FeCo alloy with thickness of 3Å a layer and nonmagnetic layers of Fe-SiO2 deposited alternatively on a glass substrate by using high frequency magnetron spattering technique. The thickness of Fe-SiO2 layers were controlled in a range of 50 - 170Å a layer.

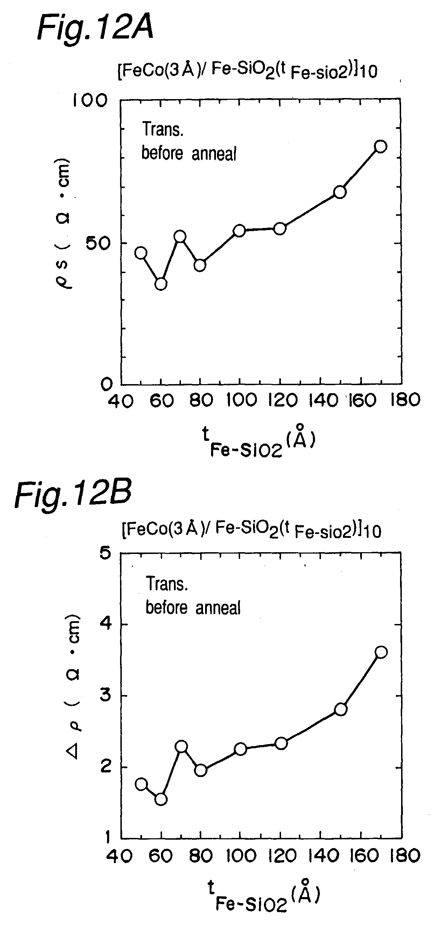

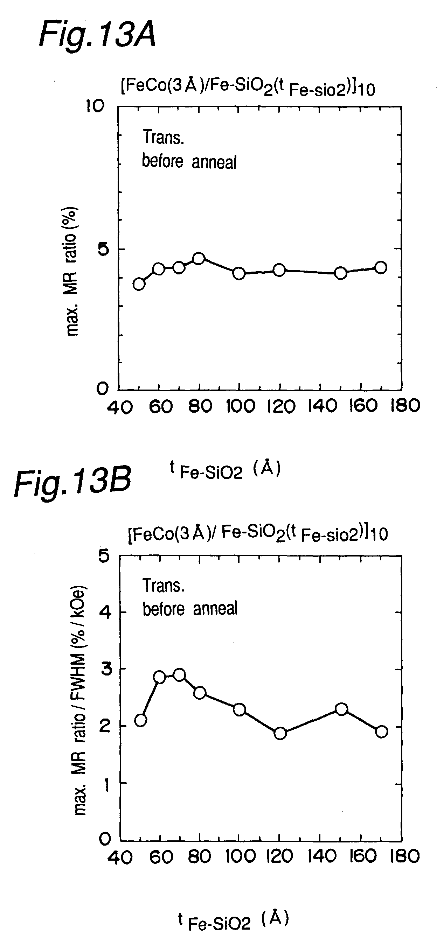

Magnetoresistance and MR ratios were measured for the multilayers [FeCo(3Å)/Fe-SiO2(tÅ)]10 varying in thickness t of each of nonmagnetic layers. In Figure 13A the maximum MR ratio is within 4 and 5%, independently of the thickness of 50 - 170Å and in Figure 13B magnetic sensitivity is slightly high in thickness of 60 - 80Å. The multilayers FeCo/Fe-SiO2 have features of showing higher specific electric resistance than the multilayers described above. Figure 12A shows saturated specific resistance is increased as the thickness of the layer Fe-SiO2 increases, and Figure 12B shows that the difference Δρ between saturated specific resistance ρₛ and maximum specific resistance ρ₀ at zero magnetic field also is increased as the thickness increases.

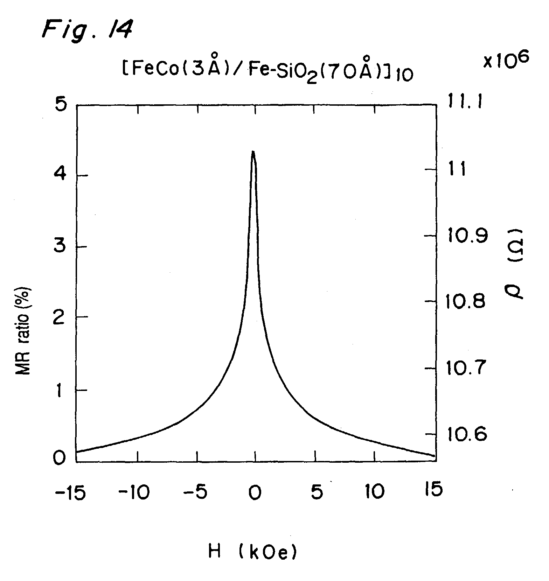

MR ratio of the multilayer [FeCo(3Å)/Fe-SiO2(tÅ)]10 as deposited, as shown in figure 14, is sharpened with a great deal of MR ratio change in a range of ±3 Koe. The multilayer measured have the very high resistance, as shown in this Figure 14.

### (EXAMPLE 5)

Multilayers Fe-SiO2/Co-Ag were formed of ferromagnetic layers of Fe-SiO2 with thicknesses 3Å and 5Å and nonmagnetic layers of Co-Ag deposited alternatively on a glass substrate by using high frequency magnetron spattering technique. The thicknesses of a Co-Ag layer were controlled in a range of 50 - 150Å.

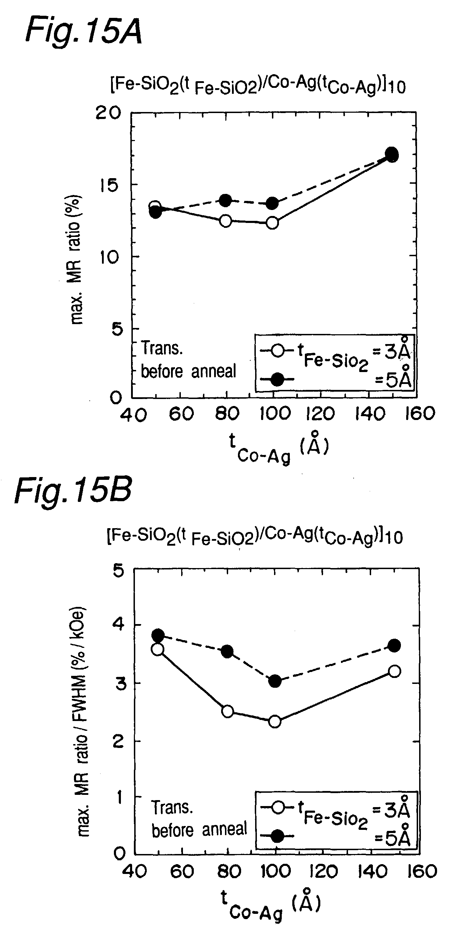

Resistance and MR ratios were measured for the multilayers [Fe-SiO2(3/5Å)/Co-Ag(tÅ)10 varying in thickness t a nonmagnetic layer. As shown in Figure 15A maximum MR ratio is about 13% in a range of the thickness of 50 - 100Å and then increased to 17% in 150Å. In Figure 15B, magnetic sensitivity is slightly decreased as the thickness increase from 50 to 100Å and increased again in 150Å of the thickness.

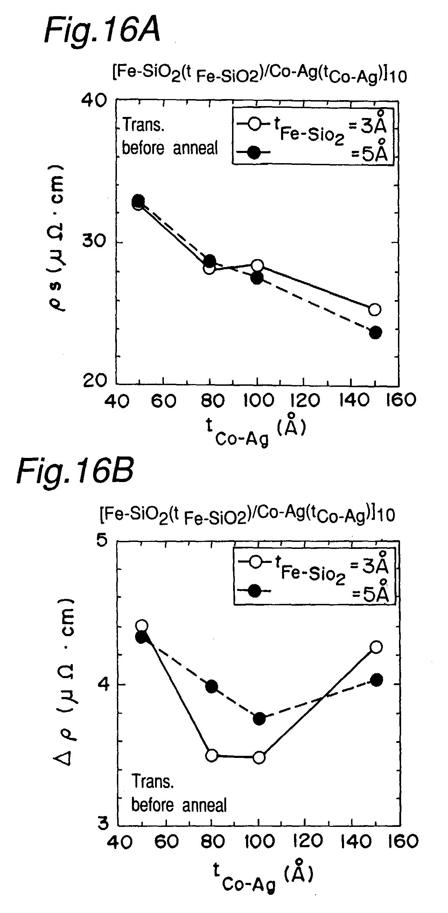

Figure 16A shows that the multilayers Fe-SiO2/Co-Ag have low specific electric resistance than the multilayers of Example 4. Figure 16A shows saturated specific resistance ρₛ is reduced as the thickness of the layer Co-Ag increases, and Figure 16B shows that the difference Δρ between saturated specific resistance and maximum specific resistance at zero magnetic field also is increased as the thickness increases up to 100Å and recovered at 150Å.

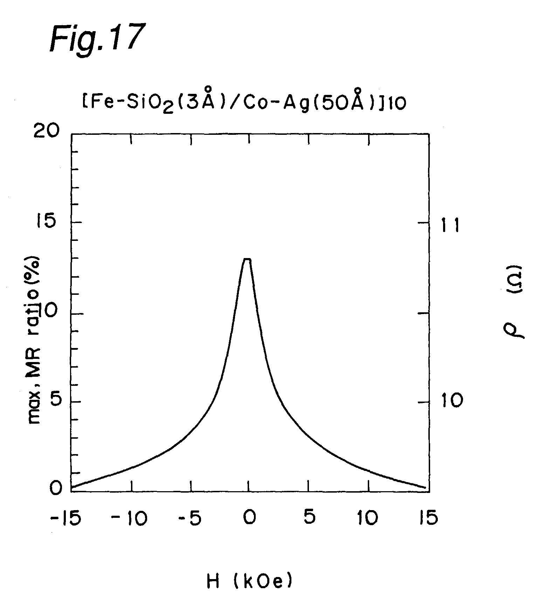

The MR ratio curve of the multilayer [Fe-SiO2(3Å)/Co-Ag(50Å)10 as deposited, as shown in figure 17, is sharpened with a great deal of MR ratio change in a range of ±3 Koe.

## Claims

1. A magnetoresistive effect sensor having a multilayer structure formed by alternatively depositing ferromagnetic layers of Co and nonmagnetic layers of Au or Ag, wherein the nonmagnetic layers contain Co particles dispersed non-uniformly therein so as to have magnetoresistive effect in a range of 1 - 2 Koe.

2. A magnetoresistive effect sensor according to Claim 1, wherein the nonmagnetic layers are deposited with Ag and have the thickness in a range of 5 - 9 Å a layer.

3. A method of producing a magnetoresistive effect sensor having a multilayer structure formed of ferromagnetic layers and nonmagnetic layers, wherein the method comprises steps of depositing alternatively Co to form layers to form the ferromagnetic layers and Ag or Au to form the nonmagnetic layers on a substrate, and annealing the multilayer to cause Co from the ferromagnetic layers to disperse as Co particles non-uniformly in the nonmagnetic layers.

4. A method according to Claim 3, wherein Au is deposited for the nonmagnetic layers and the annealing temperature is in a range of 200 - 350°C.

5. A method according to Claim 3, wherein Ag is deposited for the nonmagnetic layers and the annealing temperature is in a range of 200 - 400°C.

6. A magnetoresistive effect sensor having a multilayer structure formed by alternatively depositing ferromagnetic layers and nonmagnetic layers, wherein the ferromagnetic layers are deposited of any one of FeCo, FeNi and FeNiCo alloys to form soft magnetic layers, the nonmagnetic layers are deposited of Au or Ag, and the nonmagnetic layers are granular layers which contain any of Fe, Co and Ni particles dispersed non-uniformly therein by annealing the multilayer so as to have magnetoresistive effect in a range of 1 - 2 Koe.

7. A magnetoresistive effect sensor according to Claim 6, wherein the ferromagnetic layers are deposited of the FeCo alloy, and the nonmagnetic layers have the thickness in a range of 80 - 200 Å a layer.

8. A method of producing magnetoresistive effect sensor having a multilayer structure formed of ferromagnetic layers and nonmagnetic layers, wherein the method comprises steps of depositing alternatively FeCo alloy to form soft magnetic layers as the ferromagnetic layers and Ag-Co to form the nonmagnetic layers on a substrate, and annealing the multilayer to causes Co existing in the soft magnetic layers to disperse as Co particles non-uniformly in the nonmagnetic layers.

9. A method of producing a magnetoresistive effect sensor according to claim 8, the annealing temperature is in a range of 200 - 400 °C to grow the Co crystalline particles in the nonmagnetic layers.

10. A magnetoresistive effect sensor having a multilayer structure formed by alternatively depositing ferromagnetic layers of Fe-Co alloy and nonmagnetic layers of SiO₂ with Fe particles contained as granular layers, the multilayer having granular giant magnetoresistive effect in a range of 1 - 2 Koe.

11. A magnetoresistive effect sensor according to Claim 10, wherein the nonmagnetic layers have the thickness in a range of 50 - 100Å.

12. A magnetoresistive effect sensor having a multilayer structure formed by alternatively depositing ferromagnetic layers of Fe with SiO2 contained as soft magnetic layers and nonmagnetic layers of Ag with Co particles contained as granular layers, the multilayer having granular giant magnetoresistive effect in a range of 1 - 2 Koe.

13. A magnetoresistive effect sensor according to Claim 12, wherein the nonmagnetic layers have the thickness in a range of 50 - 80Å or 100 - 150Å.
